# EUROPÄISCHE PATENTSCHRIFT

(11) **EP 0 629 773 B1**
(45) Veröffentlichungstag und Bekanntmachung des Hinweises auf die Patenterteilung: **06.08.1997**
(21) Anmeldenummer: 94108814.8
(22) Anmeldetag: 08.06.1994
(51) Int. Cl.: F02B 77/08, G01R 31/00, G07C 5/08

(54) **Diagnoseverfahren für Kraftfahrzeuge zum Überprüfen elektronisch gesteuerter Systeme**
Vehicle diagnostic method for testing electronically controlled systems
Méthode diagnostique adaptée à un véhicule pour contrôler des systèmes réglés électroniquement

(30) Priorität: 18.06.1993 DE 4320173
(43) Veröffentlichungstag der Anmeldung: 21.12.1994
(73) Patentinhaber: Bayerische Motoren Werke Aktiengesellschaft, 80788 München (DE)
(72) Erfinder: Schneider, Josef, D-85250 Altomünster (DE); Hohenner, Hans, D-80331 München (DE)
(74) Vertreter: Dirscherl, Josef

(56) Entgegenhaltungen:
- EP-A- 0 071 523
- DE-C- 4 106 717
- US-A- 4 375 672
- US-A- 4 757 463
- US-A- 4 796 206

## Beschreibung

Die Erfindung betrifft ein Diagnoseverfahren für Kraftfahrzeuge nach dem Oberbegriff des Patentanspruchs 1 bzw. 2.

Ein Diagnoseverfahren für Kraftfahrzeuge mit einem Diagnosegerät zum Überprüfen eines elektronisch gesteuerten Systems, bei dem ein in einem elektronischen Steuergerät vorgesehener Fehlerspeicher abgefragt wird, ist beispielsweise aus der DE 34 37 980 A1 bekannt. Bei diesem bekannten Verfahren ist eine Vorrichtung vorgesehen, mit der zur Diagnose der Mikrorechner eines elektronischen Steuergerätes durch einen alternativ in eine Steckverbindung einsteckbaren Diagnosemikrorechner ersetzt wird, der zusätzlich zu Diagnosefunktionen auch die Funktionen des serienmäßig eingebauten Mikrorechners beinhaltet. In einem Fehlerspeicher des Steuergerätes werden erkannte Fehler bzw. Fehlfunktionen gespeichert und können vorzugsweise in der Werkstatt über einen Anschluß am Diagnosemikrorechner auf eine externe Auswertevorrichtung übertragen werden.

Externe Auswertevorrichtungen sind in der Praxis beispielsweise derart ausgestaltet, daß nicht nur die aus dem Fehlerspeicher zu entnehmende Information, sondern auch entsprechend dieser Information auszuführende Prüfschritte zur genauen Fehlerortung angezeigt werden. Wie beispielsweise der DE 41 18 692 A1 zu entnehmen ist, gibt der Fehlerspeicher beispielsweise eine Fehlernummer, die Fehlerart und Betriebsparameter, die bei Auftreten des Fehlers vorliegen, an. Die Fehlerart kann beispielsweise Kurzschluß nach Masse, Kurzschluß nach Plus oder Unterbrechung sein. Die Fehlernummer gibt beispielsweise an, welche Komponente oder welcher elektrische Pfad fehlerhaft ist. Eine derartige Fehlernummer ist jedoch nur eine funktionelle Fehlerinformation, die zwar den Fehlerort eingrenzt, jedoch nicht genau angeben kann.

Eine mögliche Fehlerinformation ist beispielsweise das Fehlen eines bestimmten Sensorsignals. Dieser Fehler ist jedoch auf mehrere mögliche Ursachen zurückzuführen: Z.B. Unterbrechung an einer beliebigen Stelle im Kabelbaum oder durch einen nicht vollständig geschlossenen Stecker oder durch eine defekte, diesem Sensorsignal zugeordnete Eingangsschaltung im Steuergerät.

Die aufgrund einer Fehlerinformation vorgegebenen Prüfschritte dienen daher zum Auffinden der genauen Fehlerursache. Da in der Praxis häufig ohne Durchführen der Prüfschritte die für einen bestimmten Fehler in Frage kommenden Komponenten, insbesondere die elektronischen Steuergeräte, willkürlich ausgetauscht werden, entstehen unnötig hohe Reparaturkosten. Auch werden Komponenten zur Reparatur eingesendet, die jedoch intakt sind.

Aus der DE-A-4106717 ist ein Diagnoseverfahren für Kraftfahrzeuge mit einem Diagnosegerät zum Überprüfen elektronisch gesteuerter Systeme bekannt, bei dem ein in einem elektronischen Steuergerät vorgesehener Fehlerspeicher abgefragt wird und bei dem automatisch auszuführende Prüfschritte vorgegeben werden. Die auf die automatisch vorgegebenen Prüfschritte hin ausgeführten Prüfschritte werden teilweise zur Fehlermeldung, teilweise für weitere Tests erfaßt. Prüfschritte, die nicht automatisch durchgeführt werden können, werden im Dialog zwischen dem Benutzer des Diagnosegeräts (z. B. Werkstattfachmann) und dem Diagnosegerät als manuelle Prüfschritte vorgegeben. Bei diesem bekannten Diagnoseverfahren wird nicht überprüft, ob die vorgegebenen manuellen Prüfschritte korrekt ausgeführt wurden. Somit ist auch eine Überwachung der manuell durchgeführten Prüfschritte nicht vorgesehen.

Es ist Aufgabe der Erfindung, insbesondere in der Werkstatt, bei Diagnosevorgängen Funktions- und Fehlerüberprüfungen zu überwachen bzw. eine korrekte Funktions- und Fehlerüberprüfung sicherzustellen.

Diese Aufgabe wird durch die Merkmale der Patentansprüche 1 und 2 gelöst.

Die Prüfschritte, die beispielsweise ein Werkstattfachmann auf die Vorgabe der auszuführenden Prüfschritte hin ausführt, werden vom Diagnosegerät oder vom Steuergerät zumindest teilweise erfaßt. Vorzugsweise werden diese erfaßten ausgeführten Prüfschritte im Diagnosegerät und/oder im Steuergerät abgespeichert.
Durch dieses erfindungsgemäße Vorgehen liegt eine Dokumentation der ausgeführten Prüfschritte vor. Diese Dokumentation kann auf verschiedene Weise verwendet werden. Allein das Wissen eines Werkstattfachmanns über die Nachweisbarkeit seiner ausgeführten Prüfschritte wird zu einer korrekten Funktions- und Fehlerüberprüfung motivieren. Dies führt zu einer Behebung der tatsächlichen, nicht nur der vermuteten Fehler, wodurch die Verfügbarkeit des elektronisch gesteuerten Systems erhöht wird.

Die erfaßten Prüfschritte werden vorzugsweise nicht nur in beliebiger Form, sondern in der zeitlichen Reihenfolge, in der sie ausgeführt wurden, erfaßt.
Mit dieser zusätzlichen Dokumentation der zeitlichen Reihenfolge der ausgeführten Prüfschritte wird überwacht, ob die Fehlerüberprüfung sinnvoll durchgeführt wurde. Beispielsweise soll eine Komponente nicht vor einer vollständigen Fehlersuche ausgetauscht werden. Auch ist es sinnvoll den Fehlerspeicher erst nach Behebung des Fehlers zu löschen.

Die erfaßten Prüfschritte werden im Steuergerät oder im Diagnosegerät mit zumindest einer Auswahl der auszuführenden Prüfschritte verglichen. Eine mögliche Auswahl richtet sich z.B. danach, ob die für das Auffinden einer Fehlerursache wichtigsten Prüfschritte durchgeführt wurden.
Damit wird bereits automatisch durch das Steuergerät oder das Diagnosegerät festgestellt, ob eine korrekte Fehlerüberprüfung stattgefunden hat. Aufgrund dieses automatischen Vergleichs sind auch automatische Reaktionen des Steuergeräts oder des Diagnosegeräts aufgrund des Vergleichsergebnisses möglich.

Ein mögliches Ergebnis des automatischen Vergleichs ist beispielsweise die Information, daß ein auszuführender Prüfschritt bei den erfaßten Prüfschritten nicht enthalten ist. Daraufhin wird eine dieser Information entsprechende Meldung angezeigt und/oder abgespeichert. Vorzugsweise wird diese Meldung am Diagnosegerät angezeigt und im Steuergerät abgespeichert.
Durch diese automatische Meldung oder Abspeicherung nur einer Information wird eine Kontrolle der Funktionsüberprüfung vereinfacht.

Ein weiteres mögliches Ergebnis des automatischen Vergleichs ist die Information, daß die erfaßten Prüfschritte in ihrer Reihenfolge von der Reihenfolge der auszuführenden Prüfschritte abweichen. In diesem Fall wird ebenfalls eine dieser Information entsprechende Meldung angezeigt und/oder abgespeichert. Auch hier findet vorzugsweise eine Abspeicherung im Steuergerät und eine Anzeige im Diagnosegerät statt.

Eine Meldung nach Patentanspruch 1 oder 2 kann beispielsweise eine Aufforderung zur Wiederholung der Prüfschritte sein, eine Warnung, das die auszuführenden Prüfschritte mit den vorgegebenen Prüfschritten nicht übereinstimmen oder welche Prüfschritte nicht durchgeführt wurden.

Die ausgeführten und erfaßten Prüfschritte und/oder beliebige Meldungen werden in einer bevorzugten Ausführungsform nicht-flüchtig in dem zu überprüfenden Steuergerät abgespeichert. Für eine nicht-flüchtige Speicherung werden vorzugsweise EEPROMs eingesetzt.
Diese erfindungsgemäße Ausgestaltung dient insbesondere dazu, daß auch in einem Steuergerät, das von der Spannungsversorgung abgesteckt und zur Reparatur gegeben wurde, kontrolliert werden kann, ob nur ein willkürlicher Tausch des Steuergerätes vorgenommen wurde oder ob Fehler der anderen Komponenten als Ursache für den abgespeicherten Fehler ausgeschlossen wurden.

Bei Eintreten der zu erwartenden Wirkung aufgrund des erfindungsgemäßen Diagnoseverfahrens werden erhebliche Kosten bei Reparaturvorgängen eingespart.

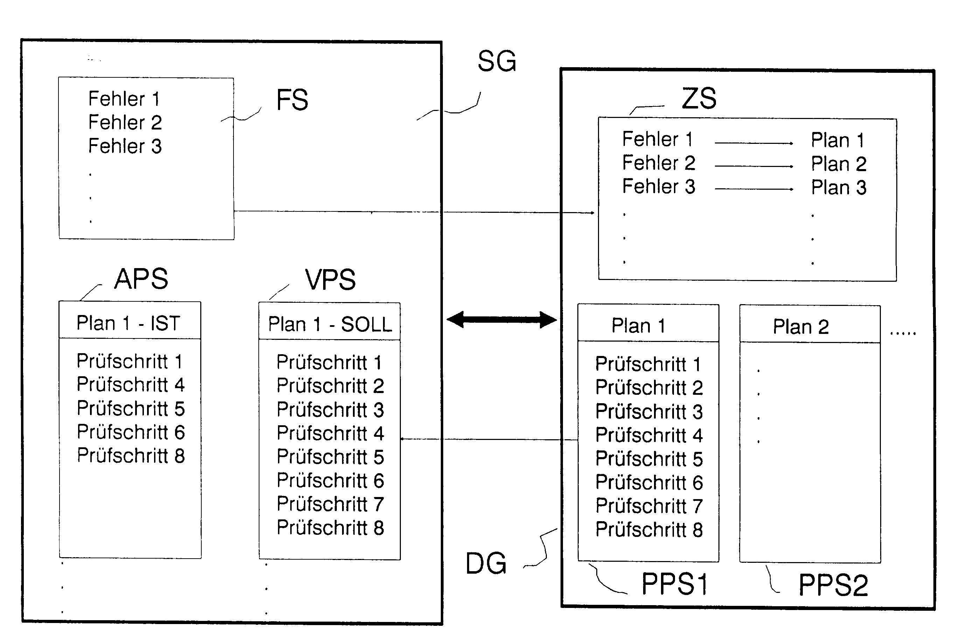

In der Zeichnung ist ein Ausführungsbeispiel der Erfindung dargestellt. Sie zeigt einen möglichen Austausch von Informationen zwischen einem Steuergerät und einem Diagnosegerät nach einem erfindungsgemäßen Diagnoseverfahren.

Die Zeichnung enthält ein Steuergerät SG und ein Diagnosegerät DG. Zwischen dem Steuergerät SG und dem Diagnosegerät DG ist zum Austausch von Daten beispielsweise eine bidirektionale Leitung vorgesehen. Sowohl das Steuergerät SG als auch das Diagnosegerät DG sind mikroprozessorgesteuert und enthalten hier nicht dargestellte Rechner. Darüber hinaus enthält das Steuergerät SG einen Fehlerspeicher FS, in dem bei Auftreten von Fehlern in dem diesen Steuergerät SG zugeordneten System entsprechend eines bekannten Fehlererkennungsprogramms beispielsweise Fehlerart, Fehlerort und Fehlerhäufigkeit abgespeichert wird. Beispielsweise wird in der Werkstatt mit dem Diagnosesteuergerät DG dieser Fehlerspeicher FS ausgelesen und über eine hier nicht dargestellte Anzeige des Diagnosegeräts DG angezeigt. Das Diagnosegerät DG enthält einen Zuordnungsspeicher ZS, in dem jedem aufgetretenen Fehler (Fehler 1, Fehler 2, Fehler 3...) ein eigener Prüfplan (Plan 1, Plan 2, Plan 3...) zugeordnet ist. Weiterhin sind im Diagnosegerät DG Prüfplanspeicher PPS1, PPS2 vorgesehen, in denen die für jeden Prüfplan vorgesehenen Prüfschritte (Prüfschritt 1, Prüfschritt 2, ...) entsprechend einer vorgegebenen Reihenfolge abgespeichert sind. Beispielsweise gibt der Plan 1 acht Prüfschritte vor, die ein Werkstattfachmann der Reihe nach auszuführen hat. Der jeweils vorgegebene Prüfplan ist dem Steuergerät SG bekannt oder wird dem Steuergerät SG übermittelt und in einem Vorgabeprüfplanspeicher VPS abgelegt. Darüber hinaus ist im Steuergerät SG ein aktueller Prüfplanspeicher APS vorgesehen, in dem die tatsächlich ausgeführten Prüfschritte des Werkstattfachmanns erfaßt und abgespeichert werden. Der Vorgabeprüfplanspeicher VPS und der aktuelle Prüfplanspeicher APS sind vorzugsweise nicht-flüchtige Speicher. Dadurch kann deren Inhalt auch bei abgestecktem Steuergerät SG über das Diagnosegerät DG abgefragt und verglichen werden.

Es ist jedoch auch möglich, daß das Steuergerät SG selbst die beiden Speicherinhalte vergleicht und z.B. in einem eigenen Speicher (hier nicht dargestellt) die Information abspeichert, ob die Speicherinhalte identisch sind oder nicht. In diesem Fall ist es möglich, mit dem Diagnosegerät DG nur diese Meldung abzufragen, wenn eine genaue Dokumentation der tatsächlich ausgeführten Prüfschritte nicht benötigt wird. Stellt das Diagnosegerät DG fest, daß der Vorgabeprüfplanspeicher VPS und der aktuelle Prüfplanspeicher APS in ihren Inhalten nicht übereinstimmen, ist beispielsweise eine Anzeige am Diagnosegerät zur Wiederholung der vorgegebener Prüfschritte möglich.

Es folgt ein Beispiel für die Anwendung des erfindungsgemäßen Diagnoseverfahrens entsprechend dem Inhalt des lerspeichers eines Motorsteuergerätes:

Ein Werkstattfachmann liest mittels des Diagnosegeräts (DG) den Fehlerspeicher (FS) eines Motorsteuergerätes (SG) aus. Im Fehlerspeicher (FS) sei die Fehlermeldung "Einspritzventil 1 Kurzschluß gegen Masse" abgespeichert. Das Diagnosegerät (DG) schreibt aufgrund dieser Fehlermeldung mittels des Zuordnungsspeichers (ZS) den stattfachmann folgenden Prüfplan vor:
1. Motor abstellen
2. Einspritzventil 1 ansteuern
3. Zuleitungen zum Einspritzventil überprüfen und erneuern, falls fehlerhaft
4. Einspritzventil erneuern, wenn Zuleitungen in Ordnung
5. Fehlerspeicher löschen

Diese fünf Prüfschritte müssen in der vorgegebenen Reihenfolge durchgeführt werden. Wenn der Werkstattfachmann tatsächlich nur
1. Einspritzventile wechselt
2. den Fehlerspeicher löscht

wird im aktuellen Prüfplanspeicher (APS) lediglich der Prüfschritt vier und fünf abgespeichert, wodurch festgestellt werden kann, daß die Prüfschritte eins bis drei nicht durchgeführt wurden.

Wird diese falsche Vorgehensweise des Werkstattfachmanns festgestellt, kann beispielsweise eine Aufforderung des Werkstattfachmanns zur erneuten Durchführung des vorgegebenen Prüfplans z.B. über das Diagnosegerät (DG) angezeigt werden. Aufgrund einer festgestellten falschen Vorgehensweise sind beliebige Maßnahmen möglich, um bei Wiederholung der Prüfschritte den Werkstattfachmann zum Durchführen des vorgegebenen Prüfplans zu motivieren.

Durch die Verwendung von nicht-flüchtigen Speichern ist ein Nachweis einer falschen Vorgehensweise bei der Durchführung der Prüfschritte auch bei abgestecktem Steuergerät (SG) möglich, wodurch ein willkürliches Austauschen von Komponenten ohne Durchführung der Prüfschritte verhindert wird.

Auch wird die Verfügbarkeit von elektronisch gesteuerten Systemen durch die Behebung der tatsächlichen, nicht nur der vermuteten Fehler erhöht.

## Patentansprüche

1. Diagnoseverfahren für Kraftfahrzeuge mit einem Diagnosegerät zum Überprüfen elektronisch gesteuerter Systeme, bei dem ein in einem elektronischen Steuergerät vorgesehener Fehlerspeicher abgefragt wird und bei dem auszuführende Prüfschritte vorgegeben werden, wobei die auf die vorgegebenen Prüfschritte hin ausgeführten Prüfschritte zumindest teilweise erfaßt werden, dadurch gekennzeichnet, daß die erfaßten Prüfschritte mit einer Auswahl der auszuführenden Prüfschritte verglichen werden und daß eine Meldung angezeigt und/oder abgespeichert wird, wenn ein auszuführender Prüfschritt in den erfaßten Prüfschritten nicht enthalten ist.

2. Diagnoseverfahren für Kraftfahrzeuge mit einem Diagnosegerät zum Überprüfen elektronisch gesteuerter Systeme, bei dem ein in einem elektronischen Steuergerät vorgesehener Fehlerspeicher abgefragt wird und bei dem auszuführende Prüfschritte vorgegeben werden, wobei die auf die vorgegebenen Prüfschritte hin ausgeführten Prüfschritte zumindest teilweise erfaßt werden, dadurch gekennzeichnet, daß die erfaßten Prüfschritte in ihrer zeitlichen Reihenfolge aufgenommen werden, daß die erfaßten Prüfschritte mit einer Auswahl der auszuführenden Prüfschritte verglichen werden und daß eine Meldung angezeigt und/oder abgespeichert wird, wenn die erfaßten Prüfschritte in ihrer Reihenfolge von einer vorgegebenen Reihenfolge der auszuführenden Prüfschritte abweichen.

3. Diagnoseverfahren nach Patentanspruch 1 oder 2, dadurch gekennzeichnet, daß die ausgeführten und erfaßten Prüfschritte und/oder die Meldung nichtflüchtig in dem zu überprüfenden Steuergerät abgespeichert werden.

## Claims

1. A method of diagnosis for motor vehicles comprising a diagnostic device for checking electronically controlled systems, wherein a fault memory provided in an electronic control device is interrogated and wherein required test steps are preset and the test steps carried out in response to the preset test steps are at least partly detected, characterised in that the detected test steps are compared with a selection of the required test steps and a report is displayed and/or stored if a required test step is not included in the detected test steps.

2. A method of diagnosis for motor vehicles comprising a diagnostic device for checking electronically controlled systems, wherein a fault memory provided in an electronic control device is interrogated and wherein required test steps are preset and the test steps carried out in response to the preset test steps are at least partly detected, characterised in that the detected test steps are recorded in the sequence in which they occur, the detected test steps are compared with a selection of the required test steps, and a report is displayed and/or stored if the detected test steps differ in their sequence from a preset sequence in which the test steps are to be carried out.

3. A method of diagnosis according to claim 1 or 2, characterised in that the test steps carried out and detected and/or the report are stored in non-volatile manner in the control device under test.

## Revendications

1. Procédé de diagnostic pour véhicules automobiles, utilisant un appareil de diagnostic pour contrôler des systèmes à commande électronique, selon lequel on interroge une mémoire de défauts prévue dans un appareil de commande électronique, on prédétermine les étapes de contrôle à exécuter, et on saisit au moins partiellement les étapes de contrôle exécutées suivant les étapes prédéterminées, caractérisé en ce qu'
• on compare les étapes de contrôle saisies à une sélection d'étapes de contrôle à exécuter et
• on affiche et/ou on met en mémoire un message lorsqu'une étape de contrôle à exécuter n'est pas contenue dans les étapes de contrôle, saisies.

2. Procédé de diagnostic pour des véhicules automobiles avec un appareil de diagnostic pour contrôler les systèmes de commande électroniques,
selon lequel,
• on interroge une mémoire de défauts prévue dans un appareil de commande électronique,
• on prédétermine les étapes de contrôle à exécuter,
• on saisit au moins partiellement les étapes de contrôle exécutées en fonction des étapes de contrôle prévues,
caractérisé en ce que
• on enregistre les étapes de contrôle saisies dans leur ordre chronologique,
• on compare les étapes de contrôle saisies à une sélection d'étapes de contrôle à exécuter, et
• on affiche et/ou on met en mémoire un message si l'ordre des étapes de contrôle saisies diffère d'un ordre prédéterminé d'étapes de contrôle à exécuter.

3. Procédé de diagnostic selon les revendications 1 ou 2, caractérisé en ce que on met en mémoire de manière non fugitive les étapes de contrôle exécutées et saisies et/ou l'information dans l'appareil de commande à contrôler.
